# EUROPEAN PATENT SPECIFICATION

(11) **EP 4 597 121 B1**
(45) Date of publication and mention of the grant of the patent: **18.11.2026**
(21) Application number: 24154660.5
(22) Date of filing: 30.01.2024
(51) Int. Cl.: G01R 15/20, G01R 33/00, G01R 33/09

(54) **CURRENT TRANSDUCER WITH TMR MAGNETIC FIELD SENSOR**
STROMWANDLER MIT TMR-MAGNETFELDSENSOR
TRANSDUCTEUR DE COURANT À CAPTEUR DE CHAMP MAGNÉTIQUE TMR

(43) Date of publication of application: 06.08.2025
(73) Proprietor: LEM International SA, 1217 Meyrin (CH)
(72) Inventor: SCHLÄFLI, M. Dominik, 1260 NYON (CH)
(74) Representative: reuteler & cie SA

(56) References cited:
- WO-A1-2023/217356
- JP-A- 2008 170 368
- US-A1- 2017 322 052
- US-A1- 2019 018 083

## Description

The present invention relates to a current transducer with a tunnel magnetoresistance (TMR) magnetic field sensor.

It is known to provide current transducers with TMR magnetic field sensors configured for measuring a magnetic field generated by a primary conductor positioned adjacent the in-plane magnetic field sensor. The primary conductor may typically have a U-shaped portion with parallel first and second branches joined together at one end by a bridging portion. The gradient sensor in such case may typically have a first sensing element positioned adjacent and overlapping one of the primary conductor branches and a second sensing element positioned adjacent and overlapping the other primary conductor branch. The current in the first and second branches flows in opposite directions and a magnetic field gradient is thus generated in a direction transverse to the first and second branches and may thus be picked up by the TMR magnetic field sensor.

Certain TMR based sensors comprise four TMR resistors arranged in a Wheatstone bridge circuit (also commonly referred to as a full bridge), each of the resistors of the Wheatstone bridge consisting of a TMR resistor.

The spaced apart layout of the TMR resistors on a substrate of the TMR sensor in environments subject to thermal gradients, mechanical stress, or magnetic field gradients, affects the TMR resistors to different extents depending on their position on the substrate, which leads to measurement errors. Moreover, the measurement error is accentuated in current transducers with a pair of TMR magnetic field sensors since the current measurement is based on the output of both TMR sensors, each comprising a measurement error.

TMR sensors are very accurate if they are well calibrated and balanced, however imbalances due external factors that impinge upon the resistors of the Wheatstone bridge in different manners, can lead to inacceptable measurement errors which cannot be easily compensated.

US 2017/0322052 A1 relates to a magnetoresistive Wheatstone bridge comprising two bridge branches connected in parallel between a supply potential, wherein two series-connected resistor arrangements are provided in each bridge branch with an interposed measuring potential.

JP 2008/170368 A relates to a magnetic field detection apparatus comprising a Wheatstone bridge circuit having a plurality of resistance units, wherein at least one of the resistance units includes an element group in which a plurality of magnetoresistive elements are connected in parallel.

US 2019/018083 A1 relates to a magnetic sensor comprising an array of tunnel magnetoresistive elements, each having fixed and free magnetic layers separated by an insulating layer, the tunnel resistance of which varies with an external magnetic field.

WO 2023/217356 A1 relates to a vectorial magnetic field sensor for measuring at least a Z-component of a magnetic field perpendicular to an X/Y-plane, in which a Wheatstone bridge configuration of four magnetically sensitive resistors is arranged.

In view of the foregoing it is an object of the invention to provide a current transducer with TMR magnetic field sensors that is accurate and reliable even in the presence of gradients in magnetic fields, temperature, or stress that affect the response of the TMR sensors.

It is advantageous to provide a current transducer that is compact.

It is advantageous to provide a current transducer that is cost effective to produce.

It is advantageous to provide a current transducer that is easy to interconnect and control with external circuitry.

Objects of the invention have been achieved by providing a current transducer with TMR magnetic field sensor according to claim 1. Dependent claims set forth various advantageous embodiments.

Disclosed herein is a current transducer comprising a housing, a secondary conductor arrangement, and a magnetic field sensor connected to the secondary conductor arrangement, the magnetic field sensor including at least a first Tunnel Magnetoresistance (TMR) sensor, the TMR sensor comprising a die substrate, a Wheatstone bridge circuit arranged on the die substrate, and supply and measurement output connection terminals arranged on the die substrate for connecting the Wheatstone bridge circuit to an external circuit for power supply and measurement signal processing via the secondary conductor arrangement, the Wheatstone bridge circuit comprising four circuit branches, each circuit branch interconnecting a supply terminal to a measurement output terminal and comprising a respective TMR resistor.

According to an embodiment of the invention, each TMR resistor comprises a first TMR half-resistor and a second TMR half-resistor interconnected in series, the first and second TMR half-resistors arranged in diametrically opposed quadrants of the die substrate.

In an advantageous embodiment, the magnetic field sensor comprises a second TMR sensor arranged in a spaced apart relationship from the first TMR sensor, configured to measure a magnetic field gradient.

In an advantageous embodiment, the current transducer further comprises a primary conductor comprising a first connection end terminal and a second connection end terminal.

In an advantageous embodiment, the primary conductor comprises an intermediate section interconnecting the first and second connection end terminals, the intermediate section having a first branch, a second branch and a bridging branch interconnecting one end of the first branch to one end of the second branch, the first and second branches separated by a gap.

In an advantageous embodiment, the primary conductor comprises an intermediate section interconnecting the first and second connection end terminals, the intermediate section of reduced cross-sectional area compared to the first and second connection end terminals, the first and second connection end terminals separated by a gap.

In an advantageous embodiment, the magnetic field gradient sensor is mounted on a surface of the primary conductor separated therefrom by an insulating layer.

In an advantageous embodiment, the primary conductor, secondary conductor arrangement, and magnetic field gradient sensor are overmolded by the insulating housing except for connection terminals of the primary conductor and secondary conductor arrangement.

In an advantageous embodiment, the primary conductor and secondary conductor arrangement are formed from a lead frame.

In an advantageous embodiment, each TMR resistor comprises a plurality of TMR elements connected in series by conductive interconnect track sections.

In an advantageous embodiment, the plurality of TMR elements for each TMR half resistor is greater than one hundred.

In an advantageous embodiment, the interconnect track sections are arranged on at least a first layer and a second layer of the substrate and the TMR elements form an interconnection between the first and second layers.

In an advantageous embodiment, each TMR resistance section comprises a pinned ferromagnetic layer mounted on the substrate first layer, and a free ferromagnetic layer mounted on the substrate second layer.

In an advantageous embodiment, the TMR elements of said plurality of TMR elements are spaced apart from adjacent series connected TMR elements at substantially equal distances.

In an advantageous embodiment, the TMR elements of each TMR half-resistor are arranged in positions extending from a centre region of the die substrate to proximate an outer border of the die substrate.

In an advantageous embodiment, respective said TMR sensor terminals comprise a pair of said output terminals and a pair of said supply terminals each of the terminals arranged in outer corners of the four quadrants.

Further objects and advantageous features of the invention will be apparent from the claims, from the detailed description, and annexed drawings, in which:
Figure 1a is perspective view of a current transducer according to an embodiment of the invention;
Figure 1b is perspective view of a current transducer according to another embodiment of the invention;
Figure 2 is a schematic circuit diagram of a TMR full bridge magnetic field sensor according to the prior art;
Figures 2a and 2b are schematic circuit diagrams of possible arrangements of the TMR resistors to explain the problems related to non-centroid arrangement;
Figures 3a and 3b are similarly further exemplary layouts of non-centroid arrangements of TMR resistors to explain the problems of a non-centroid arrangement;
Figure 4 is a schematic circuit diagram of a circuit layout of a TMR magnetic field sensor of a current transducer according to embodiments of the invention;
Figures 5a and 5b are simplified schematic diagrams of a layout of TMR resistors of a TMR magnetic field sensor according to an embodiment of the invention;
Figures 6a and 6b are similar to figures 5a and 5b of a variant;
Figure 7a is a schematic top view of a TMR magnetic field sensor of a current transducer according to an embodiment of the invention, although it should be noted that the TMR resistors and interconnections are not drawn to scale and are enlargened and simplified to illustrate the concept, whereby showing the actual design to scale would hamper visibility because of the sub-micrometric scale of the TMR resistor elements and interconnections which may be in a large number in the range of over a hundred to several thousand;
Figure 7b is a perspective view of the embodiment of figure 7a;
Figure 7c is a detailed partial view of a center portion of the embodiment of figure 7b.

Referring to the figures, a current transducer 100 according to embodiments of the invention comprises a magnetic field gradient sensor 2, a secondary conductor arrangement 114, and a housing 104 enclosing or encapsulating the magnetic field gradient sensor and a portion of the secondary conductor arrangement. The housing 104 may comprise an overmolding as is *per* se well known in the art of current transducers.

In an advantageous embodiment, the current transducer may include a primary conductor 105, the housing 104 enclosing or encapsulating the primary conductor partially, leaving contact terminals exposed for connection to an external circuit.

In other embodiments, the current transducer may be provided without a primary conductor incorporated therein, configured for mounting in proximity of an external primary conductor. For instance a primary conductor 105 may be provided on or within a circuit board of an external circuit on which the current transducer is mounted and connected to.

The current transducer may further optionally comprise a signal conditioning chip 103 electrically connected to the magnetic field gradient sensor 2. The signal conditioning chip 103 may include electrostatic discharge (ESD) protection diodes and/or a temperature sensor in the form of a temperature diode. In a variant (not shown), the signal conditioning chip may be omitted and the magnetic field gradient sensor may be directly connected to the secondary conductor arrangement.

The magnetic field gradient sensor comprises at least one TMR sensor connected to the signal conditioning chip or to the secondary conductor arrangement, for instance via bond wires. In preferred embodiments, the magnetic field gradient sensor comprises a pair of TMR sensors in spaced apart arrangement.

The current transducer 100 further comprises a secondary conductor arrangement 114 electrically connected to the magnetic field gradient sensor 2, temperature sensor and signal conditioning chip 103 (if present), for power and signal communication with an external circuit. Electrical interconnections between the signal conditioning chip 103, magnetic field gradient sensor 2 and secondary conductor arrangement 114 may be effected by various *per se* known interconnects 116 such as bond wires or solder beads in a flip-chip interconnection. In preferred embodiments, the interconnects 116 between the chip and the secondary conductor arrangement is performed with bond wires such that the signal conditioning chip 103 may be positioned closer to the primary conductor 105 and further from the secondary conductor arrangement 114.

The primary conductor 105 and secondary connector arrangement 114 may be stamped and formed from a lead frame, in other words cut-out of a strip of sheet metal as *per se* well known in the art of current transducers.

In the illustrated embodiments, the secondary conductor arrangement 114 has connection terminals provided with surface mount pads exposed on a mounting side 118 of the housing 104. The primary conductor 105 has first and second connection end terminals 110a, 110b that may advantageously be in the form of surface mount connection pads configured for surface mount connection of the current transducer on an external circuit board. Such surface mount connection configurations are also well known in the field of current transducers. The primary conductor and secondary conductor arrangement may however have connection terminals with other forms and configurations, such as with pin contacts, for connection to external circuit, without departing from the scope of the invention.

As well known in the art of current transducers, the primary conductor is configured to the connected to a conductor carrying a current to be measured that flows through the primary conductor and generates a magnetic field that is correlated to the amplitude of the primary current to be measured.

The magnetic field gradient sensor 2 comprises a first TMR sensor 2a and a second TMR sensor 2b, configured to measure a magnetic field within a measurement plane that extends across and overlies (or underlies) the first TMR sensor 2a and the second TMR sensor 2b. The measurement plane is a plane parallel to a major surface of the primary conductor 105 which in the illustrated embodiments is parallel to the mounting side 118 of the current transducer.

In an advantageous embodiment, the primary conductor 105 has a first branch 106a, a second branch 106b and a bridging branch 108 interconnecting one end of the first branch to one end of the second branch, such that the primary conductor has a substantially U-shaped portion. The ends of the first and second branches opposite the bridging branch 108 are each connected to a connection end terminal, the first branch 106a connected to a first connection end terminal 110a and the second branch 106b connected to a second connection end terminal 110b. As mentioned previously, the connection end terminals may for instance have the form of surface mount pads for surface mount connection to conductive traces on a circuit board. A width ***W*** of each of the first and second connection end terminal may advantageously be over 30% of a total width ***WT*** of the current transducer in order to provide good electrical and especially thermal connection to an external circuit board on which the transducer is intended to be connected.

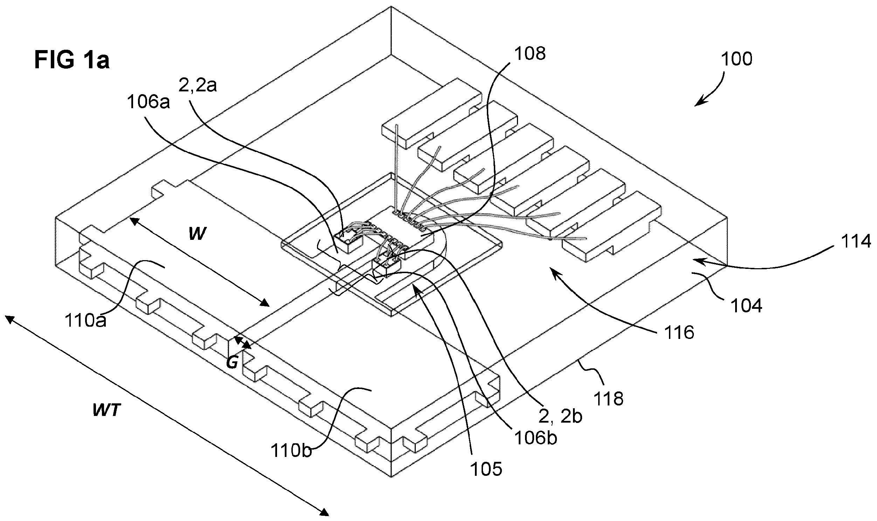

In an advantageous embodiment illustrated in figure 1a, the first TMR sensor 2a is positioned overhead (overlapping) the first branch 106a of the primary conductor and the second TMR sensor 2b is positioned overhead (overlapping) the second branch 106b of the primary conductor. The first and second TMR sensors may be mounted on an upper surface of the primary conductor, separated therefrom by an insulating layer. The insulating layer may for instance be a polyimide layer or another polymer layer typically of less than 0.5 mm thickness.

The first TMR sensor 2a and second TMR sensor 2b are made of a semiconductor chip having for instance a silicon substrate on which TMR sensors are realized. The first branch 106a and second branch 106b may extend substantially parallel to each other and symmetrically arranged and shaped about a centre line C. The centre line may however not necessarily correspond to a line that extends through a centre of the current transducer housing.

Each branch has an inner edge 122, the inner edges of the first and second branches facing each other and are separated by a gap G.

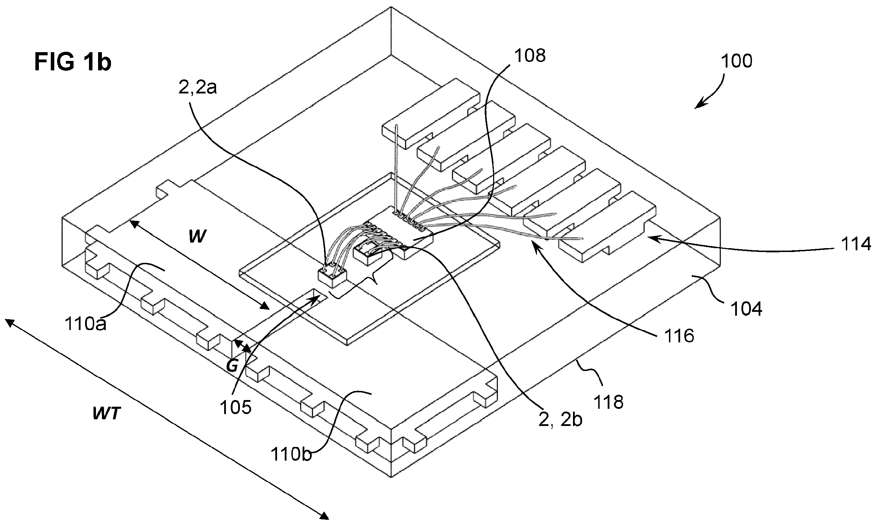

In another embodiment illustrated in figure 1b, the primary conductor comprises an intermediate section interconnecting the first and second connection end terminals 110a, 110b, the intermediate section being of reduced cross-sectional area compared to the first and second connection end terminals, and the first and second connection end terminals separated by a gap (G). In this embodiment the first TMR sensor 2a may be positioned overhead the intermediate section, and the second TMR sensor 2b may be positioned at a spacing not overhead the intermediate section, configured to measure a magnetic field gradient generated by the primary conductor 105.

Although the primary and secondary conductors have been described as being formed from lead frames, in variants it is possible to have the primary and/or secondary conductor formed by other *per se* known technologies such as by depositing metal tracks on a substrate.

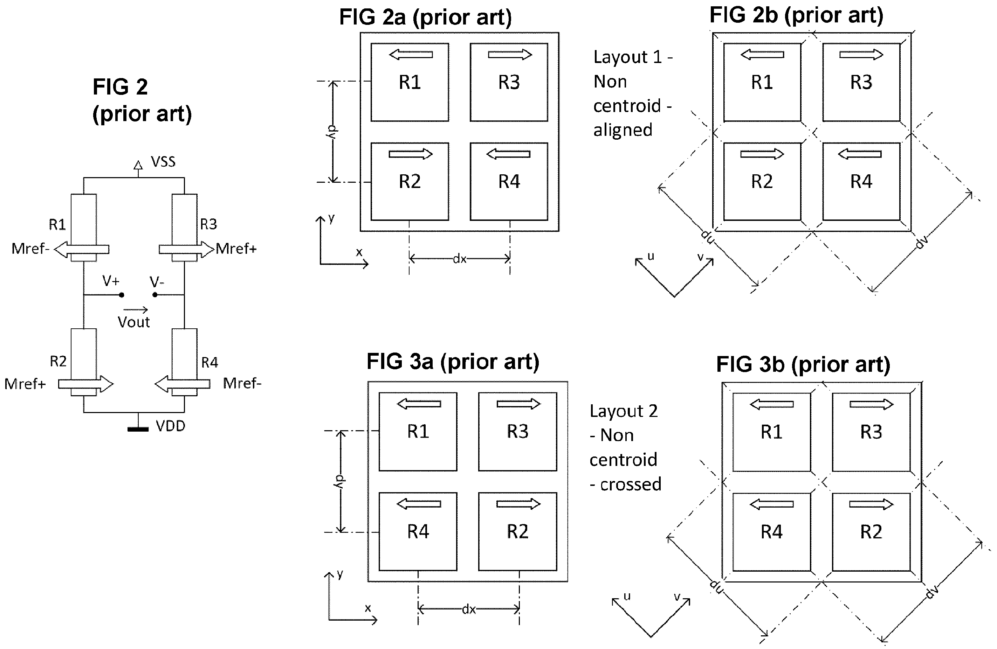

Referring to the prior art TMR sensor arrangements of figures 2 to 3b, the problems associated with conventional non-centroid TMR resistor arrangements of a TMR sensor for a current transducer, subject to external effects that create gradients are explained.

The circuit in figure 2 is a full bridge magnetoresistive sensor. The arrows indicate the direction of the pinned or reference layer magnetization. In the context of this study the magnetization of the reference layer is parallel to the x axis, and the sensitivity of the sensors is also along the x axis, meaning they respond to the x component of the B field (magnetic flux density).

A possible layout according to the state of the art is shown in Figure 2a and 2b, with the patches labelled Ri representing the area of the sensor on which TMR elements are connected in series to form resistance Ri as represented in the electrical circuit of Figure 2. These elements each have a magnetoresistive response, and in this model we consider these resistances to have a linearized response, and that the behavior of the TMR series array can be approximated by an equivalent lumped TMR localized at the center of gravity of the patch. These centers of gravity are separated by distances dx and dy, and the coordinates used in the model for patch R1a are (-dx/2,+dy/2), as an example.

Gradients along the x and y axis are modelled, and for simplicity gradients along the diagonal axis have been modelled within an u,v coordinate system.

The temperature and magnetic field have been modeled in an approximate way by a field over x,y or u,v respectively, with a homogeneous common mode component and coefficients for the gradients along the axis:
In the x,y case: $DeltaT \left(x, y\right) : = ΔT \left(1+{a}_{x}x+{a}_{y}y\right)$ $Bx \left(x, y\right) : = {B}_{0 x} \left(1+{b}_{x}x+{b}_{y}y\right)$ In the u,v case: $DeltaT \left(u, v\right) : = ΔT \left(1+{a}_{u}u+{a}_{v}v\right)$ $Bx \left(u, v\right) : = {B}_{0 x} \left(1+{b}_{u}u+{b}_{v}v\right)$

Temperature has been chosen here as an example of an influence quantity that is easy to model. It can stand in for other influence quantities to which the sensor will have some unwanted response, and similar influences of the underlying symmetry can be expected for the various components of mechanical stress, for example.

### Case 1 - shifted layout

The two half bridges are simply placed next to each other along the x axis as illustrated in figures 2a, 2b.

Ideal response - assuming homogeneous B field along x, and uniform temperature, a resistance insensitive to temperature, and a magnetoresistance insensitive to temperature, the normalized bridge output (independent of bridge supply voltage) is:
*B*₀*ₓS*₀

Simply the applied common mode field B₀ₓ times the linearized magnetic sensitivity S₀

### Effect of the gradient in the magnetic field

As these sensors will operate within a gradient sensor, the magnetic field may not be homogeneous and have a gradient component extending over the space occupied by the sensor. This model covers this case, showing here the first 3 terms of a polynomial approximation of the sensor response:
Magnetic field gradient component bₓ ${S}_{0} {B}_{0 x} - \frac{{{S}_{0}}^{2} {b}_{x} {{dxB}_{0 x}}^{2}}{2} + \frac{{{S}_{0}}^{3} {{b}_{x}}^{2} {dx}^{2} {{B}_{0 x}}^{3}}{4} + …$
Magnetic field gradient component b_{y} ${S}_{0} {B}_{0 x} + \frac{{{S}_{0}}^{3} {{b}_{y}}^{2} {dy}^{2} {{B}_{0 x}}^{3}}{4} + …$
Magnetic field gradient component bᵤ ${S}_{0} {B}_{0 x} - \frac{{{S}_{0}}^{2} {{b}_{u}}^{2} {du}^{2} {{B}_{0 x}}^{2}}{16} + \frac{{{S}_{0}}^{3} {{b}_{u}}^{2} {du}^{2} {{B}_{0 x}}^{3}}{16} + …$
Magnetic field gradient component bᵥ ${S}_{0} {B}_{0 x} - \frac{{{S}_{0}}^{2} {{b}_{v}}^{2} {dv}^{2} {{B}_{0 x}}^{2}}{16} + \frac{{{S}_{0}}^{3} {{b}_{v}}^{2} {dv}^{2} {{B}_{0 x}}^{3}}{16} + …$

What is evident is that in the presence of a field gradient the sensor response becomes nonlinear with higher order terms in B₀ₓ, also proportional to gradient*spacing. The most typical situation will involve a gradient along x.

### Effect of a temperature gradient on Offset due to resistance TCR

Temperature field gradient component aₓ
   0
Temperature field gradient component a_{y}
   0
Temperature field gradient component aᵤ $\frac{{{TC}_{R}}^{2} {{a}_{u}}^{2} {du}^{2} {ΔT}^{2}}{\left({{TC}_{R}}^{2}{{a}_{u}}^{2}{du}^{2}-16{{TC}_{R}}^{2}\right) {ΔT}^{2} - 32 {TC}_{R} ΔT - 16}$
Temperature field gradient component aᵥ $\frac{{{TC}_{R}}^{2} {{a}_{v}}^{2} {dv}^{2} {ΔT}^{2}}{\left({{TC}_{R}}^{2}{{a}_{v}}^{2}{dv}^{2}-16{{TC}_{R}}^{2}\right) {ΔT}^{2} - 32 {TC}_{R} ΔT - 16}$

### Effect of a temperature gradient on sensor response due to TMR temperature coefficient alone, 3^{rd} order polynomial approximation:

Homogeneous temperature rise $\left({S}_{0}{TC}_{M}ΔT+{S}_{0}\right) {B}_{0 x} + …$
Temperature field gradient component aₓ $\left({S}_{0}{TC}_{M}ΔT+{S}_{0}\right) {B}_{0 x} + …$
Temperature field gradient component a_{y} $\left({S}_{0}{TC}_{M}ΔT+{S}_{0}\right) {B}_{0 x} + \frac{\left({{S}_{0}}^{3}{{TC}_{M}}^{3}{{a}_{y}}^{2}{dy}^{2}{ΔT}^{3}+{{S}_{0}}^{3}{{TC}_{M}}^{2}{{a}_{y}}^{2}{dy}^{2}{ΔT}^{2}\right) {{B}_{0 x}}^{3}}{4} + …$
Temperature field gradient component aᵤ $\begin{matrix}\left({S}_{0}{TC}_{M}ΔT+{S}_{0}\right) {B}_{0 x} - \frac{{{S}_{0}}^{2} {{TC}_{M}}^{2} {{a}_{u}}^{2} {du}^{2} {ΔT}^{2} {{B}_{0 x}}^{2}}{16} \\ + \frac{\left({{S}_{0}}^{3}{{TC}_{M}}^{3}{{a}_{u}}^{2}{du}^{2}{ΔT}^{3}+{{S}_{0}}^{3}{{TC}_{M}}^{2}{{a}_{u}}^{2}{du}^{2}{ΔT}^{2}\right) {{B}_{0 x}}^{3}}{16} + …\end{matrix}$
Temperature field gradient component aᵥ $\begin{matrix}\left({S}_{0}{TC}_{M}ΔT+{S}_{0}\right) {B}_{0 x} - \frac{{{S}_{0}}^{2} {{TC}_{M}}^{2} {{a}_{v}}^{2} {dv}^{2} {ΔT}^{2} {{B}_{0 x}}^{2}}{16} \\ + \frac{\left({{S}_{0}}^{3}{{TC}_{M}}^{3}{{a}_{v}}^{2}{dv}^{2}{ΔT}^{3}+{{S}_{0}}^{3}{{TC}_{M}}^{2}{{a}_{v}}^{2}{dv}^{2}{ΔT}^{2}\right) {{B}_{0 x}}^{3}}{16} + …\end{matrix}$

### Case 2 - Crossed layout

The two half bridges are crossing each other as illustrated in figures 3a, 3b

Ideal response - assuming homogeneous B field along x, and uniform temperature, a resistance insensitive to temperature, and a magnetoresistance insensitive to temperature, the normalized bridge output (independent of bridge supply voltage) is:
*B*₀*ₓS*₀

Simply the applied common mode field B₀ₓ times the linearized magnetic sensitivity S₀

### Effect of the gradient in the magnetic field

As these sensors will operate within a gradient sensor, the magnetic field may not be homogeneous and have a gradient component extending over the space occupied by the sensor. This model covers this case, showing here the first 3 terms of a polynomial approximation of the sensor response:
Magnetic field gradient component bₓ ${S}_{0} {B}_{0 x} - \frac{{{S}_{0}}^{2} {b}_{x} {{dxB}_{0 x}}^{2}}{2} + \frac{{{S}_{0}}^{3} {{b}_{x}}^{2} {dx}^{2} {{B}_{0 x}}^{3}}{4} + …$
Magnetic field gradient component b_{y} ${S}_{0} {B}_{0 x} + \frac{{{S}_{0}}^{3} {{b}_{y}}^{2} {dy}^{2} {{B}_{0 x}}^{3}}{4} + …$
Magnetic field gradient component bᵤ ${S}_{0} {B}_{0 x} + \frac{{{S}_{0}}^{2} {b}_{u} {{duB}_{0 x}}^{2}}{4} + \frac{{{S}_{0}}^{3} {{b}_{u}}^{2} {du}^{2} {{B}_{0 x}}^{3}}{8} + …$
Magnetic field gradient component bᵥ ${S}_{0} {B}_{0 x} - \frac{{{S}_{0}}^{2} {b}_{v} {{dvB}_{0 x}}^{2}}{4} + \frac{{{S}_{0}}^{3} {{b}_{v}}^{2} {dv}^{2} {{B}_{0 x}}^{3}}{8} + …$

What is evident is that in the presence of a field gradient the sensor response becomes nonlinear with higher order terms in B₀ₓ, also proportional to gradient*spacing. The most typical situation will involve a gradient along x.

### Effect of a temperature gradient on Offset due to resistance TCR

Temperature field gradient component aₓ $\frac{{TC}_{R} {a}_{x} dxΔT}{2 {TC}_{R} ΔT + 2}$
Temperature field gradient component a_{y}
   0
Temperature field gradient component aᵤ $- \left(\frac{{TC}_{R} {a}_{u} duΔT}{4 {TC}_{R} ΔT + 4}\right)$
Temperature field gradient component aᵥ $\frac{{TC}_{R} {a}_{v} dvΔT}{4 {TC}_{R} ΔT + 4}$

### Effect of a temperature gradient on sensor response due to TMR temperature coefficient alone, 3^{rd} order polynomial approximation:

Homogeneous temperature rise $\left({S}_{0}{TC}_{M}ΔT+{S}_{0}\right) {B}_{0 x} + …$
Temperature field gradient component aₓ $\begin{matrix}\left({S}_{0}{TC}_{M}ΔT+{S}_{0}\right) {B}_{0 x} - \frac{\left({{S}_{0}}^{2}{{TC}_{M}}^{2}{a}_{x}{dxΔT}^{2}+{{S}_{0}}^{2}{TC}_{M}{a}_{x}dxΔT\right) {{B}_{0 x}}^{2}}{2} \\ + \frac{\left({{S}_{0}}^{3}{{TC}_{M}}^{3}{{a}_{x}}^{2}{dx}^{2}{ΔT}^{3}+{{S}_{0}}^{3}{{TC}_{M}}^{2}{{a}_{x}}^{2}{dx}^{2}{ΔT}^{2}\right) {{B}_{0 x}}^{3}}{4} + …\end{matrix}$
Temperature field gradient component a_{y} $\left({S}_{0}{TC}_{M}ΔT+{S}_{0}\right) {B}_{0 x} + \frac{\left({{S}_{0}}^{3}{{TC}_{M}}^{3}{{a}_{y}}^{2}{dy}^{2}{ΔT}^{3}+{{S}_{0}}^{3}{{TC}_{M}}^{2}{{a}_{y}}^{2}{dy}^{2}{ΔT}^{2}\right) {{B}_{0 x}}^{3}}{4} + …$
Temperature field gradient component aᵤ $\begin{matrix}\left({S}_{0}{TC}_{M}ΔT+{S}_{0}\right) {B}_{0 x} + \frac{\left({{S}_{0}}^{2}{{TC}_{M}}^{2}{a}_{u}{duΔT}^{2}+{{S}_{0}}^{2}{TC}_{M}{a}_{u}duΔT\right) {{B}_{0 x}}^{2}}{4} \\ + \frac{\left({{S}_{0}}^{3}{{TC}_{M}}^{3}{{a}_{u}}^{2}{du}^{2}{ΔT}^{3}+{{S}_{0}}^{3}{{TC}_{M}}^{2}{{a}_{u}}^{2}{du}^{2}{ΔT}^{2}\right) {{B}_{0 x}}^{3}}{8} + …\end{matrix}$
Temperature field gradient component aᵥ $\begin{matrix}\left({S}_{0}{TC}_{M}ΔT+{S}_{0}\right) {B}_{0 x} - \frac{\left({{S}_{0}}^{2}{{TC}_{M}}^{2}{a}_{v}{dvΔT}^{2}+{{S}_{0}}^{2}{TC}_{M}{a}_{v}dvΔT\right) {{B}_{0 x}}^{2}}{4} \\ + \frac{\left({{S}_{0}}^{3}{{TC}_{M}}^{3}{{a}_{v}}^{2}{dv}^{2}{ΔT}^{3}+{{S}_{0}}^{3}{{TC}_{M}}^{2}{{a}_{v}}^{2}{dv}^{2}{ΔT}^{2}\right) {{B}_{0 x}}^{3}}{8} + …\end{matrix}$

From both of the simple layouts for full bridge magnetoresistive sensors it becomes evident that they have unwanted sensitivity to gradients of magnetic field, temperature, and by analogy, other influence quantities like mechanical stress.

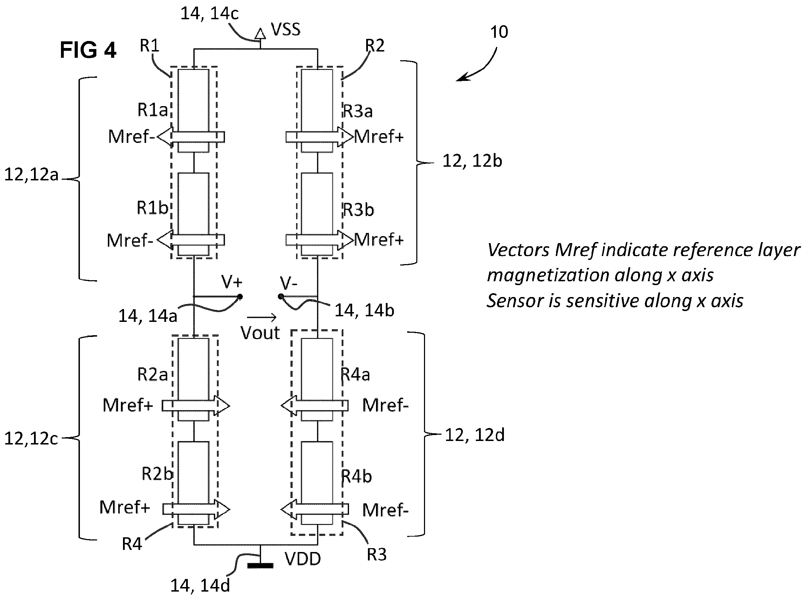

Referring now to figures 4 to 8, embodiments of the invention will now be described.

A TMR sensor according to embodiments of the invention comprises a substrate 4 and a Wheatstone bridge circuit 10 arranged on layers of the substrate. The Wheatstone bridge circuit comprises circuit branches 12 and terminals 14 including output terminals 14a, 14b and supply terminals 14c, 14d, and four circuit branches 12a, 12b, 12c, 12d interconnecting the output terminals and supply terminals in a Wheatstone bridge arrangement as *per se* well known. The output terminals comprise a first output terminal V- and the second output terminal V+ providing the measurement signal Vout of the circuit. The supply terminals 14c, 14d are for connection to first and second reference voltages VSS, VDD, for instance a reference supply voltage and a ground connection.

Each circuit branch comprises a TMR resistor, R1, R2, R3, R4. Each circuit branch resistor is formed of a plurality of series connected TMR elements each having a pinned ferromagnetic layer and a free ferromagnetic layer separated by an insulating the layer, the magnetic orientation of the pinned layer of each of the TMR elements being oriented in substantially the same direction. In other words, the orientation direction of the ferromagnetic layers of the TMR elements of each TMR resistor, R1, R2, R3, R4 are parallel to each other.

As *per se* well known, when a magnetic field orients the magnetic field of the free layer in a same direction as the pinned layer, the resistance of the TMR element is reduced proportionally to the amplitude of the magnetic field. Embodiments may include TMRs that are based on a homogeneously magnetized free layer as well as TMRs with a "vortex state" free layer. In a vortex state free layer, the magnetization vectors are arranged in a rotating pattern. The principles of operation of both of these embodiments result in a sensor response to the component of the applied magnetic field that is in the direction of the pinned layer magnetization.

According to an aspect of the invention, each branch resistor R1, R2, R3, R4 comprises a first half resistance R1a, R2a, R3a, R4a and a second half resistance of R1b, R2b, R3b, R4b arranged about a centroid in diametrically opposed quadrants 6 of a square surface area, the first and second half resistances have the same properties, namely subject to a given magnetic field under the same conditions, have substantially the same resistances.

In preferred embodiments, the TMR first and second half resistances each have a plurality of TMR elements 16 arranged in a space-apart manner within the respective quadrant 6 and interconnected by interconnect sections of conductor tracks 18, 18-1, 18-2 that interconnect the supply terminals to the output terminals. The TMR elements 16 are interconnected in series. The conductor tracks 18 preferably have interconnect sections 18-1, 18-2 arranged on first and second layers 4a, 4b of the die substrate 4 whereby interconnect sections of different circuit branches cross over each other at a center region 19 of the square surface area within which the four quadrants 6a, 6b, 6c, 6d are disposed.

Each TMR element 16 may be disposed such that the pinned layer is positioned proximate the first substrate layer 4a and the free layer positioned proximate the second substrate layer 4b. It may be noted however that the pinned and free layers of the TMR elements may be inverted or may be different from one circuit branch with respect to another circuit branch, without departing from the scope of the invention.

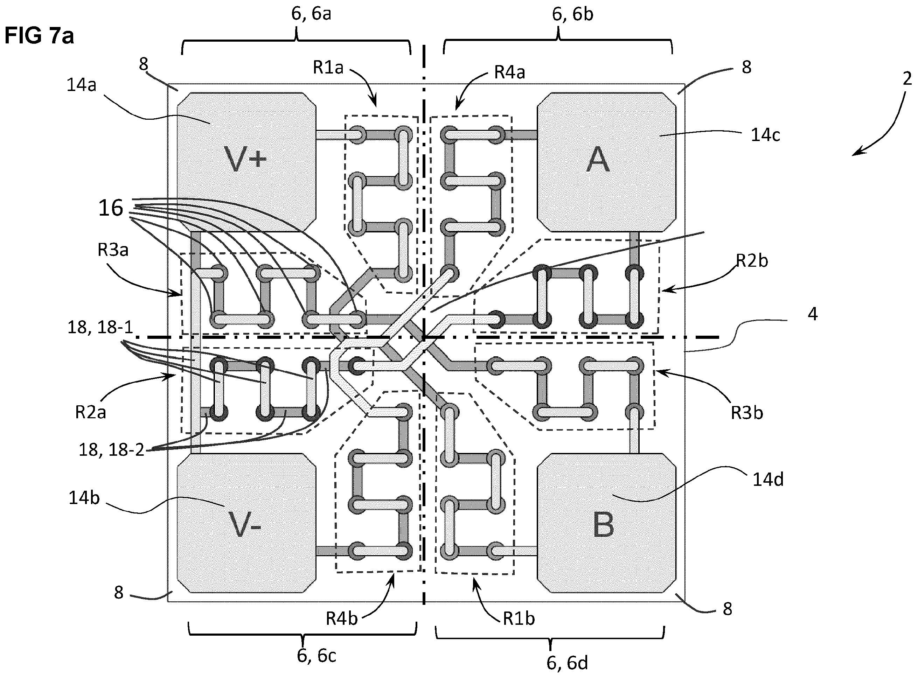

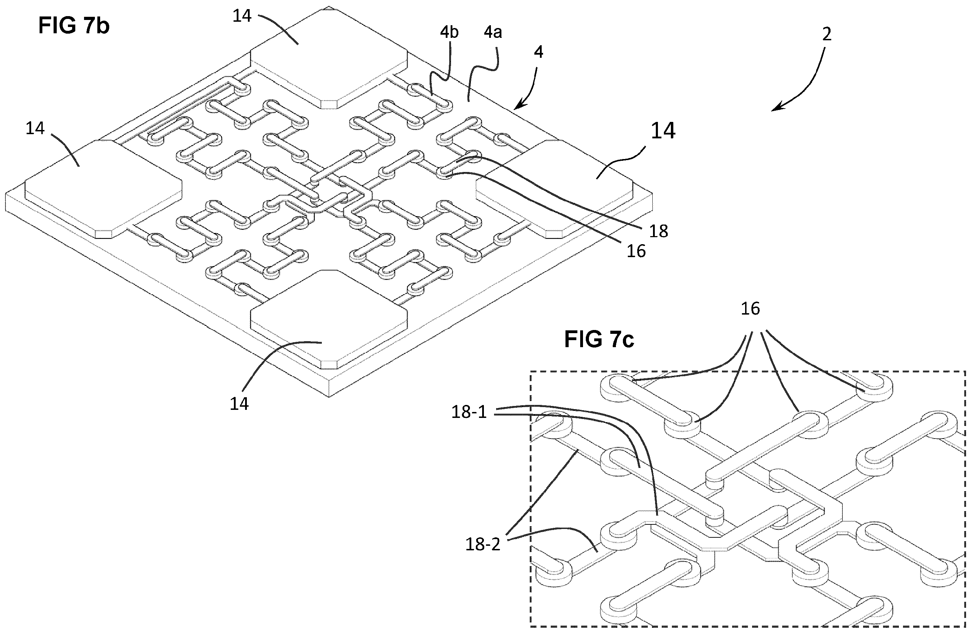

In advantageous embodiments, each half resistance R*i*a, R*i*b comprises a plurality of TMR elements which may be more than one hundred up to several thousand. The simplified drawings of figures 7a to 7c are not to scale and are intended to illustrate the concept because showing the actual layout pattern to scale would hamper visibility because of the large number and sub-micrometric scale of the TMR elements. It may be noted that increasing the number of TMR elements increases the resistance, which may be desirable, and decreases the noise, which is very desirable. The TMR elements 16 are preferably interconnected in a spaced-apart manner distributed substantially evenly spanning from the center of the square surface area to the corner of the square surface area, in order to avoid cross-talk and mutual effects between adjacent TMR elements. The spacing also facilitates the manufacturing and magnetization of the individual TMR element. The TMR insulation layer is preferably of the type MgO (magnesium oxide) as *per se* well known in the field of TMR sensors. The four terminals or bonding pads forming the pairs of measurement and supply terminals, are preferably arranged at corners of the square surface area defining the four quadrants.

Let us now consider in more detail how embodiments of the invention provides better immunity against gradient influence quantities compared to the prior art discussed previously..

### Embodiments of the invention - common centroid full bridge layout.

The electrical circuit is illustrated in figure 4. Each resistor in the full bridge is subdivided into two equal half-resistors Ria and Rib.

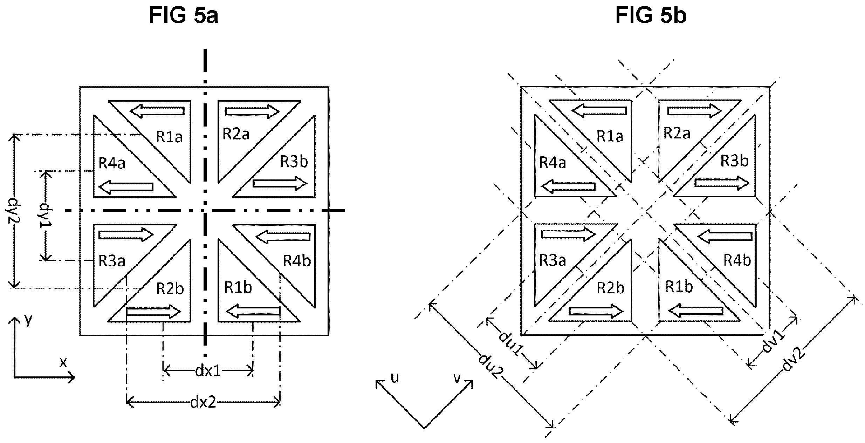

The four half-resistor pairs are then laid out so that the centroid of each half-resistor pair coincides with the center of the sensor die, for example as shown in figures 5a, 5b, although other shapes will satisfy this condition. As a consequence, the coordinates of the centroids of each half-resistor in a pair will be exhibiting a central symmetry with respect to the center of the die or the layout of the full bridge if such a full bridge would be implemented on a larger substrate.

*Ideal response:* assuming homogeneous magnetic field B along x, and uniform temperature, a resistance insensitive to temperature, and a magnetoresistance insensitive to temperature, the normalized bridge output (independent of bridge supply voltage) is:
*B*₀*ₓS*₀

Simply the applied common mode field B₀ₓ times the linearized magnetic sensitivity S₀

### Effect of the gradient in the magnetic field

As these sensors will operate within a gradient sensor, the magnetic field may not be homogeneous and have a gradient component extending over the space occupied by the sensor. This model covers this case, showing here the first three terms of a polynomial approximation of the sensor response:
Magnetic field gradient component bₓ ${S}_{0} {B}_{0 x} + …$
Magnetic field gradient component b_{y} ${S}_{0} {B}_{0 x} + …$
Magnetic field gradient component bᵤ ${S}_{0} {B}_{0 x} + …$
Magnetic field gradient component bᵥ ${S}_{0} {B}_{0 x} + …$

Polynomial approximations up to the 3^{rd} order show no non-linearity in the presence of a field gradient along the 4 axis modelled here.

### Effect of a temperature gradient on Offset due to resistance TCR

Temperature field gradient component aₓ
   0
Temperature field gradient component a_{y}
   0
Temperature field gradient component aᵤ
   0
Temperature field gradient component aᵥ
   0

### Effect of a temperature gradient on sensor response due to TMR temperature coefficient alone, 3^{rd} order polynomial approximation:

Homogeneous temperature rise $\left({S}_{0}{TC}_{M}ΔT+{S}_{0}\right) {B}_{0 x} + …$
Temperature field gradient component aₓ $\left({S}_{0}{TC}_{M}ΔT+{S}_{0}\right) {B}_{0 x} + …$
Temperature field gradient component a_{y} $\left({S}_{0}{TC}_{M}ΔT+{S}_{0}\right) {B}_{0 x} + …$
Temperature field gradient component aᵤ $\left({S}_{0}{TC}_{M}ΔT+{S}_{0}\right) {B}_{0 x} + …$
Temperature field gradient component aᵥ $\left({S}_{0}{TC}_{M}ΔT+{S}_{0}\right) {B}_{0 x} + …$

The common centroid full bridge layout is insensitive to gradients of the quantity to be measured as well as the influence quantities, due to the symmetry resulting in all four resistors of the bridge sharing a common centroid.

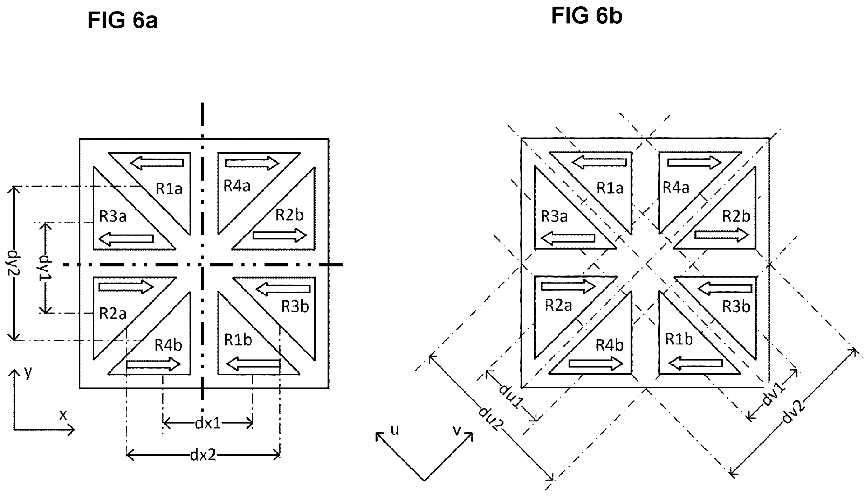

A different arrangement of the common centroid layout, example shown in figures 6a, 6b. It can be verified to satisfy the same properties using a similar model as above.

In embodiments of the invention, the symmetrical arrangement of the four resistors of the full bridge comprises a plurality of TMR elements connected in series with a layout of the crossing, advantageously using two layers of metallization and the TMR elements themselves as vias to cross from one side to the other.

There are several pinned layer magnetization patterns that are compatible with the series connection layout and crossing layout. The preferred patterns are the ones resulting in large areas of the same magnetization as this makes the pinned layer selective programming process step easier and faster.

### List of references used

**Current transducer 100**
   **Magnetic field gradient sensor 2**
      **TMR sensor 2, 2a, 2b**
      Die / substrate 4
         First layer 4a
         Second layer 4b
         Quadrants 6a, 6b, 6c, 6d
         Center
         Corner regions 8
      Wheatstone bridge circuit 10
         Circuit branches 12
         First circuit branch 12a
         Second circuit branch 12b
         Third circuit branch 12c
         Fourth circuit branch 12d
      Terminals 14
         Output terminals 14a, 14b
            First output terminal Vout-
            Second Output terminal Vout+
         Supply terminals 14c, 14d
            First supply terminal Vss
            Second supply terminal Vdd
      TMR based resistances R(N): R1, R2, R3, R4
         First branch resistance R1
         Second branch resistance R2
         Third branch resistance R3
         Fourth branch resistance R4
         1st half resistance, 2nd half resistance Ria, Rib (i=1, 2, 3, 4)
      TMR elements 16
         Pinned ferromagnetic layer
         Insulating separation layer
         Free ferromagnetic layer
      Conductor tracks 18
         Interconnect sections on pinned layer 18-1
         Interconnect sections on free layer 18-2
   **Signal conditioning chip 103**
      ESD protection diodes, Temperature sensor
   **Overmold housing 104**
      Mounting side 118
   **Primary conductor 105**
      First branch 106a
         Inner edge 122
      Second branch 106b
         Inner edge 122
      Bridging branch 108
      First Connection end terminal 110a
         Surface mount pad
      Second connection end terminal 110b
         Surface mount pad
   **Secondary conductor arrangement 114**
      Connection terminals
      Surface mount pads
   **Interconnects 116**
      Bond wires
*Centreline C*

## Claims

1. A current transducer (100) comprising a housing (104), a secondary conductor arrangement (114), and a magnetic field sensor (2) connected to the secondary conductor arrangement, the magnetic field sensor (2) including at least a first Tunnel Magnetoresistance ,TMR, sensor (2a), the TMR sensor comprising a die substrate (4), a Wheatstone bridge circuit (10) arranged on the die substrate, and supply and measurement output connection terminals (14) arranged on the die substrate for connecting the Wheatstone bridge circuit to an external circuit for power supply and measurement signal processing via the secondary conductor arrangement, the Wheatstone bridge circuit comprising four circuit branches (12), each circuit branch interconnecting a supply terminal to a measurement output terminal and comprising a respective TMR resistor, wherein each TMR resistor comprises a first TMR half-resistor and a second TMR half-resistor interconnected in series, **characterized in that** the first and second TMR half-resistors are arranged in diametrically opposed quadrants (6) of the die substrate.

2. The current transducer according to claim 1 wherein the magnetic field sensor comprises a second TMR sensor (2b) arranged in a spaced apart relationship from the first TMR sensor, configured to measure a magnetic field gradient.

3. The current transducer according to any of claims 1-2 further comprising a primary conductor (5) comprising a first connection end terminal (110a) and a second connection end terminal (110b).

4. The current transducer according to claim 3 wherein the primary conductor comprises an intermediate section interconnecting the first and second connection end terminals, the intermediate section having a first branch (106a), a second branch (106b) and a bridging branch (108) interconnecting one end of the first branch to one end of the second branch, the first and second branches separated by a gap (G).

5. The current transducer according to claim 3 wherein the primary conductor comprises an intermediate section interconnecting the first and second connection end terminals, the intermediate section of reduced cross-sectional area compared to the first and second connection end terminals, the first and second connection end terminals separated by a gap (G).

6. Current transducer according to any of claims 3-5 wherein the magnetic field gradient sensor (2) is mounted on a surface of the primary conductor separated therefrom by an insulating layer.

7. The current transducer according to any of claims 3-6 wherein the primary conductor (105), the secondary conductor arrangement (114), and the magnetic field gradient sensor (2) are overmolded by the insulating housing (104) except for connection terminals of the primary conductor and secondary conductor arrangement.

8. The current transducer according to any of claims 3-7 wherein the primary conductor and the secondary conductor arrangement are formed from a lead frame.

9. The current transducer according to any of claims 1-8 wherein each TMR resistor comprises a plurality of TMR elements connected in series by conductive interconnect track sections (18).

10. The current transducer according to claim 9 wherein the number of TMR elements, of the plurality of TMR elements, for each TMR half resistor is greater than one hundred.

11. The current transducer according to claim 10 wherein the interconnect track sections are arranged on at least a first layer and a second layer of the substrate and the TMR elements form an interconnection between the first and second layers.

12. The current transducer according to claim 11 wherein each TMR resistance section comprises a pinned ferromagnetic layer mounted on the substrate first layer, and a free ferromagnetic layer mounted on the substrate second layer.

13. The current transducer according to any of claims 9-12 wherein the TMR elements of said plurality of TMR elements are spaced apart from adjacent series connected TMR elements at substantially equal distances.

14. The current transducer according to any of claims 9-13 wherein the TMR elements of each TMR half-resistor are arranged in positions extending from a centre region of the die substrate to proximate an outer border of the die substrate.

15. The current transducer according to any of claims 1-14 wherein respective said TMR sensor terminals (14) comprise a pair of said output terminals (14a, 14b) and a pair of said supply terminals (14c, 14d) each of the terminals arranged in outer corners (8) of the four quadrants.

## Patentansprüche

1. Stromwandler (100), umfassend ein Gehäuse (104), eine sekundäre Leiteranordnung (114) und einen Magnetfeldsensor (2), der mit der sekundären Leiteranordnung verbunden ist, wobei der Magnetfeldsensor (2) mindestens einen ersten magnetischen Tunnelwiderstands-, TMR, Sensor (2a) umfasst, wobei der TMR-Sensor ein Chip-Substrat (4), eine Wheatstone-Brückenschaltung (10), die auf dem Chip-Substrat angeordnet ist, und Versorgungs-und Messausgabe-Anschlussklemmen (14), die auf dem Chip-Substrat angeordnet sind, um die Wheatstone-Brückenschaltung mit einer externen Schaltung zur Stromversorgung und Messsignalverarbeitung über die sekundäre Leiteranordnung zu verbinden, umfasst, wobei die Wheatstone-Brückenschaltung vier Schaltungszweige (12) umfasst, wobei jeder Schaltungszweig eine Versorgungsklemme mit einer Messausgangsklemme zusammenschaltet und einen jeweiligen TMR-Widerstand umfasst, wobei jeder TMR-Widerstand einen ersten TMR-Halbwiderstand und einen zweiten TMR-Halbwiderstand, die in Reihe zusammengeschaltet sind, umfasst, **dadurch gekennzeichnet, dass** der erste und der zweite TMR-Halbwiderstand in diametral entgegengesetzten Quadranten (6) des Chip-Substrats angeordnet sind.

2. Stromwandler nach Anspruch 1, wobei der Magnetfeldsensor einen zweiten TMR-Sensor (2b) umfasst, der in einem beabstandeten Verhältnis zu dem ersten TMR-Sensor angeordnet ist, der dazu konfiguriert ist, einen Magnetfeldgradienten zu messen.

3. Stromwandler nach einem der Ansprüche 1 bis 2, ferner umfassend einen primären Leiter (5), der eine erste Verbindungendklemme (110a) und eine zweite Verbindungsendklemme (110b) umfasst.

4. Stromwandler nach Anspruch 3, wobei der primäre Leiter ein Zwischenstück umfasst, das die erste und die zweite Verbindungsendklemme zusammenschaltet, wobei das Zwischenstück einen ersten Zweig (106a), einen zweiten Zweig (106b) und einen Überbrückungszweig (108), der ein Ende des ersten Zweigs mit einem Ende des zweiten Zweigs zusammenschaltet, aufweist, wobei der erste und der zweite Zweig durch einen Luftspalt (G) getrennt sind.

5. Stromwandler nach Anspruch 3, wobei der primäre Leiter ein Zwischenstück umfasst, das die erste und die zweite Verbindungsendklemme zusammenschaltet, wobei das Zwischenstück im Vergleich zu der ersten und der zweiten Verbindungsklemme im Querschnitt reduziert ist, wobei die erste und die zweite Verbindungsendklemme durch einen Luftspalt (G) getrennt sind.

6. Stromwandler nach einem der Ansprüche 3 bis 5, wobei der Magnetfeld-Gradientensensor (2) auf einer Oberfläche des primären Leiters montiert ist, die davon durch eine Isolierschicht getrennt ist.

7. Stromwandler nach einem der Ansprüche 3 bis 6, wobei der primäre Leiter (105), die sekundäre Leiteranordnung (114) und der Magnetfeld-Gradientensensor (2) von dem isolierenden Gehäuse (104) mit Ausnahme der Verbindungsanschlüsse des primären Leiters und der sekundären Leiteranordnung umspritzt sind.

8. Stromwandler nach einem der Ansprüche 3 bis 7, wobei der primäre Leiter und die sekundäre Leiteranordnung aus einem Leiterrahmen gebildet sind.

9. Stromwandler nach einem der Ansprüche 1 bis 8, wobei jeder TMR-Widerstand eine Vielzahl von TMR-Elementen umfasst, die durch leitende Zusammenschaltungsbahnstücke (18) in Reihe geschaltet sind.

10. Stromwandler nach Anspruch 9, wobei die Anzahl von TMR-Elementen der Vielzahl von TMR-Elementen für jeden TMR-Halbwiderstand größer als einhundert ist.

11. Stromwandler nach Anspruch 10, wobei die Zusammenschaltungsbahnstücke auf mindestens einer ersten Schicht und einer zweiten Schicht des Substrats angeordnet sind, und die TMR-Elemente eine Zusammenschaltung zwischen der ersten und der zweiten Schicht bilden.

12. Stromwandler nach Anspruch 11, wobei jedes TMR-Widerstandsstück eine verstiftete ferromagnetische Schicht, die auf der ersten Schicht des Substrats montiert ist, und eine freie ferromagnetische Schicht, die auf der zweiten Schicht des Substrats montiert ist, umfasst.

13. Stromwandler nach einem der Ansprüche 9 bis 12, wobei die TMR-Elemente der Vielzahl von TMR-Elementen von angrenzenden in Reihe geschalteten TMR-Elementen in im Wesentlichen gleichen Abständen beabstandet sind.

14. Stromwandler nach einem der Ansprüche 9 bis 13, wobei die TMR-Elemente jedes TMR-Halbwiderstands in Positionen angeordnet sind, die sich von einem mittleren Bereich des Chip-Substrats bis in die Nähe einer äußeren Grenze des Chip-Substrats erstrecken.

15. Stromwandler nach einem der Ansprüche 1 bis 14, wobei die jeweiligen TMR-Sensorklemmen (14) ein Paar der Ausgangsklemmen (14a, 14b) und ein Paar der Versorgungsklemmen (14c, 14d) umfassen, wobei jede der Klemmen in den äußeren Ecken (8) der vier Quadranten angeordnet ist.

## Revendications

1. Transducteur de courant (100) comprenant un boîtier (104), un agencement de conducteur secondaire (114) et un capteur de champ magnétique (2) connecté à l'agencement de conducteur secondaire, le capteur de champ magnétique (2) comportant au moins un premier capteur à magnétorésistance Tunnel, TMR, (2a), le capteur TMR comprenant un substrat de puce (4), un circuit en pont de Wheatstone (10) agencé sur le substrat de puce et des bornes de connexion d'alimentation et de sortie de mesure (14) agencées sur le substrat de puce pour connecter le circuit en pont de Wheatstone à un circuit externe pour l'alimentation de puissance et le traitement des signaux de mesure via l'agencement de conducteur secondaire, le circuit en pont de Wheatstone comprenant quatre branches de circuit (12), chaque branche de circuit interconnectant une borne d'alimentation et une borne de sortie de mesure et comprenant un résisteur TMR respectif, dans lequel chaque résisteur TMR comprend un premier demi-résisteur TMR et un deuxième demi-résisteur TMR interconnectés en série, **caractérisé en ce que** les premier et deuxième demi-résisteurs TMR sont agencés dans des quadrants (6) diamétralement opposés du substrat de puce.

2. Transducteur de courant selon la revendication 1, dans lequel le capteur de champ magnétique comprend un deuxième capteur TMR (2b) agencé de manière espacée du premier capteur TMR, configuré pour mesurer un gradient de champ magnétique.

3. Transducteur de courant selon l'une des revendications 1 et 2, comprenant en outre un conducteur primaire (5) comprenant une première borne d'extrémité de connexion (110a) et une deuxième borne d'extrémité de connexion (110b).

4. Transducteur de courant selon la revendication 3, dans lequel le conducteur primaire comprend une section intermédiaire interconnectant les première et deuxième bornes d'extrémité de connexion, la section intermédiaire ayant une première branche (106a), une deuxième branche (106b) et une branche de pontage (108) interconnectant une extrémité de la première branche et une extrémité de la deuxième branche, les première et deuxième branches étant séparées par un écart (G).

5. Transducteur de courant selon la revendication 3, dans lequel le conducteur primaire comprend une section intermédiaire interconnectant les première et deuxième bornes d'extrémité de connexion, la section intermédiaire ayant une zone de section transversale réduite en comparaison avec les première et deuxième bornes d'extrémité de connexion et les première et deuxième bornes d'extrémité de connexion étant séparées par un écart (G).

6. Transducteur de courant selon l'une des revendications 3 à 5, dans lequel le capteur de gradient de champ magnétique (2) est monté sur une surface du conducteur primaire séparée de celui-ci par une couche isolante.

7. Transducteur de courant selon l'une des revendications 3 à 6, dans lequel le conducteur primaire (105), l'agencement de conducteur secondaire (114) et le capteur de gradient de champ magnétique (2) sont surmoulés par le boîtier (104) isolant, à l'exception des bornes de connexion du conducteur primaire et de l'agencement de conducteur secondaire.

8. Transducteur de courant selon l'une des revendications 3 à 7, dans lequel le conducteur primaire et l'agencement de conducteur secondaire sont formés à partir d'une grille de connexion.

9. Transducteur de courant selon l'une des revendications 1 à 8, dans lequel chaque résisteur TMR comprend une pluralité d'éléments TMR connectés en série par des sections de piste d'interconnexion (18) conductrices.

10. Transducteur de courant selon l'une des revendications 9, dans lequel le nombre d'éléments TMR de la pluralité d'éléments TMR de chaque demi-résisteur TMR est supérieur à cent.

11. Transducteur de courant selon la revendication 10, dans lequel les sections de piste d'interconnexion sont agencées sur au moins une première couche et une deuxième couche du substrat, et les éléments TMR forment une interconnexion entre les première et deuxième couches.

12. Transducteur de courant selon la revendication 11, dans lequel chaque section de résistance TMR comprend une couche ferromagnétique fixée montée sur la première couche de substrat et une couche ferromagnétique libre montée sur la deuxième couche de substrat.

13. Transducteur de courant selon l'une des revendications 9 à 12, dans lequel les éléments TMR de ladite pluralité d'éléments TMR sont espacés d'éléments TMR connectés en série adjacents à des distances sensiblement égales.

14. Transducteur de courant selon l'une des revendications 9 à 13, dans lequel les éléments TMR de chaque demi-résisteur TMR sont agencés à des positions allant d'une région centrale du substrat de puce jusqu'à proximité d'une bordure extérieure du substrat de puce.

15. Transducteur de courant selon l'une des revendications 1 à 14, dans lequel lesdites bornes de capteur TMR (14) respectives comprennent une paire desdites bornes de sortie (14a, 14b) et une paire desdites bornes d'alimentation (14c, 14d), chacune des bornes étant agencée dans des coins extérieurs (8) des quatre quadrants.
